# EUROPEAN PATENT SPECIFICATION

(11) **EP 2 955 800 B1**
(45) Date of publication and mention of the grant of the patent: **11.04.2018**
(21) Application number: 13874731.6
(22) Date of filing: 30.05.2013
(51) Int. Cl.: H01R 31/08, H01R 13/66, H01R 13/7197, H02G 3/16, H01R 13/52, H03H 1/00

(54) **JOINT CONNECTOR WITH INTERNAL NOISE FILTER**
STECKVERBINDER MIT INTERNEM RAUSCHFILTER
CONNECTEUR DE RACCORDEMENT AVEC FILTRE DE BRUIT INTERNE

(30) Priority: 08.02.2013 JP 2013023611
(43) Date of publication of application: 16.12.2015
(73) Proprietor: AutoNetworks Technologies, Ltd., Yokkaichi-shi, Mie 510-8503 (JP); Sumitomo Wiring Systems, Ltd., Yokkaichi-shi, Mie-ken 510-8503 (JP); Sumitomo Electric Industries, Ltd., Osaka-shi, Osaka 541-0041 (JP)
(72) Inventor: AIZAWA, Takeshi, Yokkaichi-shi Mie 510-8503 (JP)
(74) Representative: Müller-Boré & Partner Patentanwälte PartG mbB
(86) International application number: PCT/JP2013/065010
(87) International publication number: WO 2014/122805

(56) References cited:
- EP-A2- 1 261 079
- EP-A2- 1 309 043
- WO-A1-2012/072044
- JP-A- H0 765 904
- JP-A- H1 186 980
- JP-A- H11 233 384
- JP-A- 2008 041 396
- JP-U- H0 363 988
- US-A- 5 455 734

## Description

### Technical Field

The present invention relates to a joint connector with internal noise filter.

### Background Art

Generally, a joint connector for collectively connecting a plurality of wires drawn out from an electronic device mounted in an automotive vehicle or the like and absorbing splices between the wires is widely used. For example, patent literature 1 discloses a joint connector with internal capacitor (hereinafter, referred to as a connector) in which a multi-pole joint terminal from which a plurality of terminal portions connected to ends of a plurality of wires project side by side at predetermined. intervals on one side edge of a busbar and a capacitor are incorporated into a housing. The joint connector and the capacitor are electrically connected in the housing and noise components superimposed on the ends of the plurality of wires connected to the connector can be collectively removed.

### Citation List

### Patent Literature

Patent literature 1:
Japanese Unexamined Patent Publication No. 2007-287642

EP 1 261 079 A2 discloses a functional connector such as a diode connector, a resistor connector, and a filter connector.

JP H11 233384 A discloses an electrolytic capacitor and a cap-type stud for the electrolytic capacitor.

EP 2 595 253 A1 discloses a USB connector. The USB connector includes a metal surface, and on the metal surface, a solid metal part is set at a location corresponding to a spring of a socket.

EP 1 309 043 A2 discloses a plug shaped terminating resistance device. detachably provided at an end of a bus line to reduce reflection noise. The bus line constitutes a bus type network for connecting a plurality of terminal communication equipments.

US 5 455 734 A discloses an insert device employing electronics non-intrusively disposed between an electronic mechanism's pins and female connector in order to provide the mechanism with electronic functional capabilities.

### Summary of the Invention

### Technical Problem

However, there is a demand to improve a noise removal ability by increasing the mounting density of noise removal elements in a connector, whereas an accommodation space in the housing extended by forming a joint terminal with multiple poles has not been effectively utilized thus far.

The present invention was completed based on the above situation and aims to enhance a noise removal ability in a multi-pole joint connector with internal noise filter including a plurality of terminal portions.

### Solution to Problem

A joint connector with internal noise filter of the prevent invention is defined in claim 1.

### Effects of the Invention

According to the present invention, by accommodating the plurality of types of noise removal elements side by side within the juxtaposition range of the terminal portions in the connector, the mounting density of the noise removal elements can be enhanced while the enlargement of the connector is avoided. Further, the plurality of types of noise removal elements to be mounted have different removable frequency bands. Thus, noise components in a wide band can be removed and a noise removal ability of the connector is improved. Furthermore, since the aluminum electrolytic capacitor is sealed by the filler, this capacitor can be reliably held in the connector housing. Further, since the filler covers only the other parts while exposing the lead wire draw-out surface of the aluminum electrolytic capacitor, the leakage of an electrolytic solution can be avoided while the aluminum electrolytic capacitor is fixed.

### Brief Description of the Drawings

FIG. 1 is a plan view in section of a joint connector with internal noise filter according to an embodiment,
FIG. 2 is a side view in section along A-A of FIG. 1, and
FIG. 3 is a side view in section along B-B of FIG. 1,

### Embodiments of the Invention

Preferred embodiments of the present invention are described.
(1) The joint connector with internal noise filter of the present invention is preferably configured such that capacitors constituting the noise removal elements are connected in parallel to the terminal fitting.
   According to this configuration, a small-size noise filter circuit can be configured by using the capacitors as the noise removal elements. Further, by connecting the respective capacitors in parallel to the terminal fitting, a wide-band noise filter circuit can be configured.
(2) The joint connector with the internal noise filter of the present invention is preferably configured such that the plurality of noise removal elements include a ceramic capacitor and the aluminum electrolytic capacitor.
   According to this configuration, a wide-band noise filter circuit can be configured by removing noise on a low frequency side by the aluminum electrolytic capacitor and removing noise on a high frequency side by the ceramic capacitor.
(3) The joint connector with internal noise filter of the present invention is preferably configured such that a first accommodation chamber and a second accommodation chamber each having an opening for incorporation are formed side by side via a separation wall in the connector housing and the aluminum electrolytic capacitor and the ceramic capacitor are respectively incorporated into the first and second accommodation chambers via the respective openings, and the filler for closing the corresponding opening is poured into the first accommodation chamber to expose the lead wire draw-out surface of the capacitor main body and cover other parts, whereas the filler for closing the corresponding opening is poured into the second accommodation chamber to surround the entire ceramic capacitor.

According to this configuration, the first accommodation chamber into which the aluminum electrolytic capacitor can be incorporated and the second accommodation chamber into which the ceramic capacitor can be incorporated are provided side by side via the separation wall and the filler is filled into each accommodation chamber, whereby each capacitor can be easily fixed in the connector housing. Further, for the first accommodation chamber, the opening is closed by filling the filler to expose the mounting surface of the aluminum electrolytic capacitor for the lead wires and cover the other parts. In this way, troubles such as the breakage of the lead wires and the leakage of an electrolytic solution can be prevented while the aluminum electrolytic capacitor is fixed in the first accommodation chamber. On the other hand, for the second accommodation chamber free from the leakage of the electrolytic solution and configured to accommodate the ceramic capacitor, the opening can be closed while the entire ceramic capacitor is surrounded by the filler. Thus, the ceramic capacitor is more reliably fixed.

Next, one specific embodiment of a joint connector with internal noise filter of the present invention is described with reference to the drawings.

### <Embodiment>

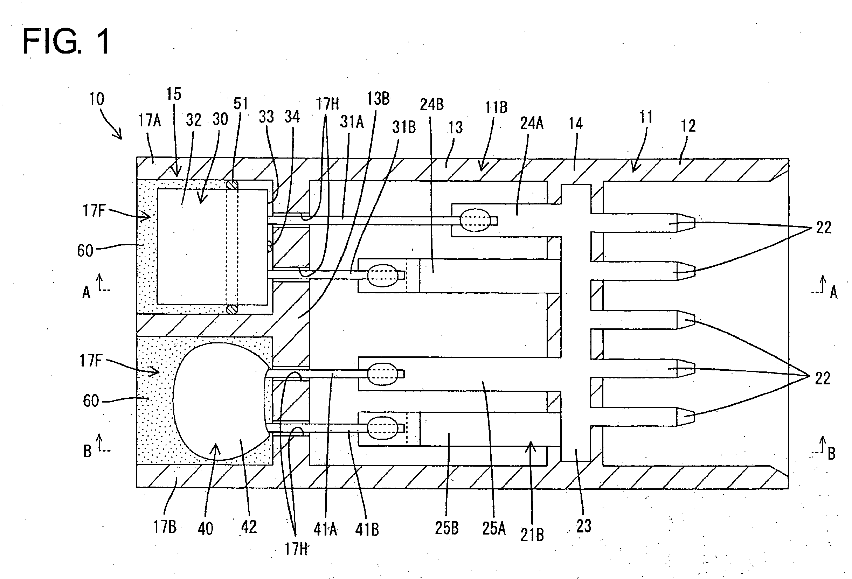

A joint connector with internal noise filter 10 (hereinafter, merely referred to as a connector 10) of this embodiment includes positive-electrode and negative-electrode busbar terminals (terminal fitting) 21A, 21B, an aluminum electrolytic capacitor 30 and a ceramic capacitor 40 for noise removal, and a connector housing 11 made of synthetic resin. Note that, in the following description, a right side and a left side of FIG. 1 are referred to as a front side and a rear side concerning a front-back direction.

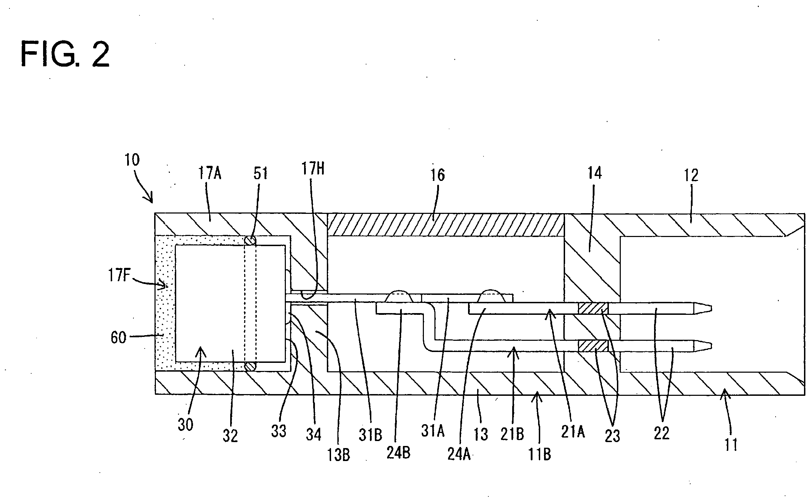

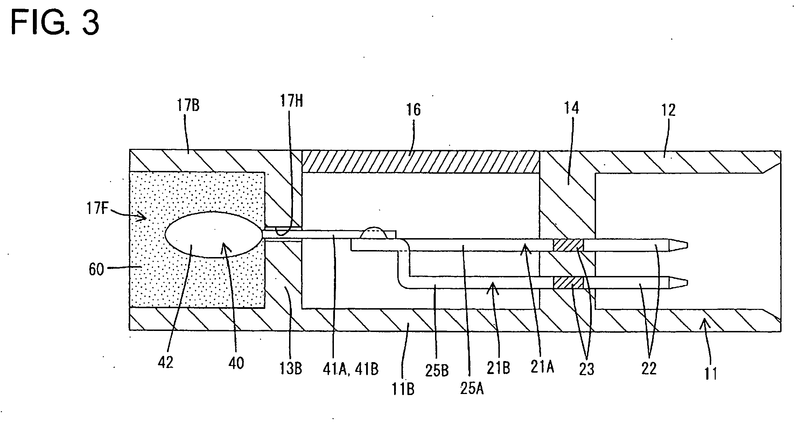

The positive-electrode and negative-electrode busbar terminals 21A, 21B are formed by punching out an electrically conductive plate member of metal such as copper alloy and applying bending and the like to punched-out pieces. As shown in FIGS. 2 and 3, the positive-electrode and negative-electrode busbar terminals 21A, 21B are arranged side by side in two stages in a height direction of the connector housing 11. The positive-electrode busbar terminal 21A is in the upper stage and the negative-electrode busbar terminal 21B is in the lower stage.

The positive-electrode busbar terminal 21A is composed of five terminal portions 22, a strip-like coupling portion 23 coupling the terminal portions 22 and a first extending portion 24A and a second extending portion 25A and connected to positive-electrode lead wires 31A, 41A of the aluminum electrolytic capacitor 30 and the ceramic capacitor 40 at the tips of the first and second extending portions 24A, 25A. The negative-electrode busbar terminal 21B is composed of five terminal portions 22, a strip-like coupling portion 23 coupling the terminal portions 22 and a third extending portion 24B and a fourth extending portion 25B and connected to negative-electrode lead wires 31B, 41B of the aluminum electrolytic capacitor 30 and the ceramic capacitor 40 at the tips of the third and fourth extending portions 24B, 25B.

The strip-like coupling portion 23 is a strip-like metal plate long in a width direction. The terminal portions 22 project side by side at predetermined intervals on one side edge of the strip-like coupling portion 23 and are in the form of tabs. The terminal portions 22 are connected to female terminal fittings (not shown) held in a mating connector (not shown) when the connector is connected to the mating connector. Further, the first to fourth extending portions 24A, 25A, 24B and 25B are formed to extend from edges of the strip-like coupling portions 23 opposite to the terminal portions 22.

The first and second extending portions 24A, 25A of the positive-electrode busbar terminal 21A are formed flat without any step in the front-back direction. On the other hand, the third and fourth extending portions 24B, 25B of the negative-electrode busbar terminal 21B are bent substantially at a right angle twice at longitudinal intermediate positions to be aligned in height with the first and second extending portions 24A, 25A for connection to the negative-electrode lead wires 31B, 41B of the respective capacitors 30, 40 as shown in FIGS. 2 and 3.

The aluminum electrolytic capacitor 30 includes an aluminum electrolytic capacitor main body 32 having a cylindrical shape, a pair of lead wires 31A, 31B drawn out forward from a front end surface (mounting surface) 33 of the aluminum electrolytic capacitor main body 32 and having positive and negative electrodes, and an insulating member 34 made of rubber and radially partitioning the front end surface 33 of the aluminum electrolytic capacitor main body 32. The positive-electrode lead wire 31A is longer than the negative-electrode lead wire 31B. Further, the insulating member 34 projects while partitioning between the lead wires 31A, 31B. The insulating member 34 functions to prevent a short circuit between the lead wires 31A, 31B when an electrolytic solution leaks out from the front end surface 33 of the aluminum electrolytic capacitor main body 32.

The ceramic capacitor 40 includes a ceramic capacitor main body 42 having a substantially oval spherical shape and a pair of lead wires 41A, 41B drawn out forward from a front end part of the ceramic capacitor main body 42. Note that the ceramic capacitor 40 has no electrode unlike the aluminum electrolytic capacitor 30. Thus, the positive-electrode lead wire 41A and the negative-electrode lead wire 41B are equal in length.

The connector housing 11 is composed of two members, i.e. a housing main body 11B substantially in the form of a box open upward, forward and backward and a lid member 16 for closing an upper opening. A receptacle 12 in the form of a rectangular tube fittable to the mating connector, a connecting part accommodating portion 13 for accommodating connecting parts of the busbar terminals 21A, 21B and the respective lead wires 31A, 31B, 41A and 41B of the respective capacitors 30, 40 and a capacitor accommodating portion 15 are provided in the connector housing 11 in an assembled state while being separated from each other.

The strip-like coupling portions 23 of the respective busbar terminals 21A, 21B are embedded in a partition wall 14 partitioning between the receptacle 12 and the connecting part accommodating portion 13 by insert molding to be held and fixed. The terminal portions 22 of the respective busbar terminals 21A, 21B project into the receptacle 12. On the other hand, the first to fourth extending portions 24A, 25A, 24B and 25B of the respective busbar terminals 21A, 21B project into the connecting part accommodating portion 13.

The upper surface of the connecting part accommodating portion 13 is open in the front-back direction from a rear wall 13B of the connecting part accommodating portion 13 to the partition wall 14 and an open part can be closed by the separate lid member 16.

The capacitor accommodating portion 15 is substantially in the form of a rectangular tube open backward. A first accommodation chamber 17A into which the aluminum electrolytic capacitor 30 can be accommodated from behind and a second accommodation chamber 17B into which the ceramic capacitor 40 can be accommodated from behind are provided in the capacitor accommodating portion 15 while being separated in the width direction as shown in FIG. 1. The respective capacitor main bodies 32, 42 can be stopped in front by the rear wall 13B of the connecting part accommodating portion 13. Further, as shown in FIG. 1, pairs of lead wire insertion holes 17H are open on the rear wall 13B.

Next, an example of an assembling procedure of the connector 10 is described. First, as shown in FIG. 2, a ring 51 made of heat resistant rubber is mounted to be held in close contact with side surfaces of the aluminum electrolytic capacitor main body 32 over the entire circumference. Then, the aluminum electrolytic capacitor 30 and the ceramic capacitor 40 are respectively inserted with the respective lead wires 31A, 31B, 41A and 41B in the lead through rear surface openings (openings) 17F of the first and second accommodation chambers 17A, 17B. Then, the respective capacitor main bodies 32, 42 are brought into contact with the rear wall 13B of the connecting part accommodating portion 13. On the other hand, the lead wires 31A, 31B, 41A and 41B of the respective capacitors 30, 40 are caused to project into the connecting part accommodating portion 13 through the lead wire insertion holes 17H.

On the other hand, the first to fourth extending portions 24A, 25A, 24B and 25B of the positive-electrode and negative-electrode busbar terminals 21A, 21B integrally incorporated by insert molding in advance are located in the connecting part accommodating portion 13. After the aluminum electrolytic capacitor 30 is accommodated, the lead wires 31A, 31B corresponding to the positive and negative electrodes of the aluminum electrolytic capacitor 30 are placed on the tips of the first and third extending portions 24A, 24B. Further, after the ceramic capacitor 40 is accommodated, the lead wires 41A, 41B corresponding to the positive and negative electrodes of the ceramic capacitor 40 are placed on the tips of the second and fourth extending portions 25A, 25B. Subsequently, a connecting operation (soldering operation) of the respective lead wires 31A, 31B, 41A and 41B and the corresponding extending portions 24A, 24B, 25A and 25B is performed through an upper surface opening of the housing main body 11B.

After the connecting operation of the respective lead wires 31A, 31B, 41A and 41B of the aluminum electrolytic capacitor 30 and the ceramic capacitor 40 and the respective busbar terminals 21A, 21B is completed in this way, the upper surface opening of the housing main body 11B is closed by the lid member 16. Subsequently, the rear surface opening 17F of each accommodating portion 17A, 17B is closed by filling epoxy resin (filler) 60. For the second accommodation chamber 17B, the rear surface opening 17F is closed by the epoxy resin 60 in a state where the ceramic capacitor main body 42 is completely covered as shown in FIG. 3. For the first accommodation chamber 17A, the rear surface opening 17F is closed by the epoxy resin 60 such that the front end surface 33 is exposed and other parts are covered as shown in FIG. 2 instead of completely cowering the aluminum electrolytic capacitor main body 32. At this time, the ring 51 made of heat resistant rubber wound on the side surfaces of the aluminum electrolytic capacitor main body 32 over the entire circumference functions as a stopper. This prevents the epoxy resin 60 from reaching the front end surface 33 of the aluminum electrolytic capacitor main body 32 when the epoxy resin 60 is poured into the first accommodation chamber 17A. By the above, an assembling operation of the connector 10 is completed.

Next, functions and effects of this embodiment are described.

Since the aluminum electrolytic capacitor 30 and the ceramic capacitor 40, which are noise removal elements, are accommodated side by side within a juxtaposition range of the terminal portions 22 of the terminal fittings 21A, 21B in the connector housing 11, the mounting density of the noise removal elements is enhanced by effectively utilizing an accommodation space in the connector housing 11 while the enlargement of the connector 10 is avoided.

Further, the connector 10 capable of removing noise in a wider band can be provided by mounting the aluminum electrolytic capacitor 30 of a high capacity excellent in a removal function of noise components on a low frequency side and the ceramic capacitor 40 excellent in a removal function of noise components on a high frequency side.

Further, the first accommodation chamber 17A for accommodating the aluminum electrolytic capacitor 30 and the second accommodation chamber 17B for accommodating the ceramic capacitor 40 are provided side by side in the connector housing 11 while being separated. For the first accommodation chamber 17A, the rear surface opening 17F is closed by the epoxy resin 60 to expose the mounting surface 33 of the aluminum electrolytic capacitor main body 32 for the lead wires 31A, 31B and cover the other parts. In this way, troubles such as the breakage of the lead wires 31A, 31B and the leakage of the electrolytic solution can be prevented while the aluminum electrolytic capacitor 30 is fixed in the first accommodation chamber 17A. On the other hand, for the second accommodation chamber 17B free from the leakage of the electrolytic solution and configured to accommodate the ceramic capacitor 40, the rear surface opening 17F can be closed while the ceramic capacitor main body 42 is entirely surrounded by the epoxy resin 60, wherefore the ceramic capacitor main body 42 can be more reliably fixed.

As described above, according to the present invention, it is possible to provide the joint connector with internal noise filter 10 with a higher noise removal function by mounting a plurality of types of capacitors 30, 40 having different. characteristics within the juxtaposition range of the terminal portions 22 in the multi-pole joint connector with internal noise filter 10 including a plurality of terminal portions 22.

### <Other Embodiments>

The present invention is not limited to the above described and illustrated embodiment. For example, the following embodiments are also included in the technical scope of the present invention.
(1) Although the aluminum electrolytic capacitor and the ceramic capacitor are used as capacitors in the above embodiment, there is no limitation to this and capacitors having different capacities and types such as a film capacitor and an electric double-layer capacitor may be used.
(2) Although two capacitors are mounted in the above embodiment, there is no limitation to this and three or more capacitors may be mounted.
(3) Although the busbar terminals are used as terminal fittings in the above embodiment, female terminal fittings and male terminal fittings other than busbar terminals may be used.
(4) Although the busbar terminals and the lead wires of the capacitors are connected by soldering in the above embodiment, there is no limitation to this and they may be connected by resistance welding or laser welding.
(5) Although the lid member is provided separately from the connector housing in the above embodiment, there is no limitation to this and the lid member and the connector housing may be integrated by being openably and closably connected via a hinge.
(6) Although the terminal portions are juxtaposed in the width direction in the above embodiment, they may be juxtaposed in the height direction. Further, in this case, the capacitors are accommodated side by side in the height direction.

### LIST OF REFERENCE SIGNS

10 ... joint connector with internal noise filter (connector)
11 ... connector housing
17A, 17B ... first, second accommodation chamber
21A, 21B ... positive-electrode, negative-electrode busbar terminal (terminal fitting)
22 ... terminal portion
30 ... aluminum electrolytic capacitor
31A, 31B ... lead wire
33 ... front end surface (mounting surface)
40 ... ceramic capacitor
17F ... rear surface opening (opening)
60 ... epoxy resin (filler)

## Claims

1. A joint connector (10) with internal noise filter, comprising:
a connector housing (11) connectable to a mating connector;
terminal fittings (21A, 21B) incorporated into the connector housing (11) and formed with a plurality of juxtaposed terminal portions (22); and
a plurality of types of noise removal elements constituting the noise filter and having different removable frequency bands,
wherein the noise removal elements are accommodated side by side in a juxtaposition direction of the terminal portions (22) within a juxtaposition range of the terminal portions (22) in the connector housing (11),
the noise removal elements include an aluminium electrolytic capacitor (30),
**characterized in that**
an opening (17F), of a first accommodation chamber (17A) provided in the connector housing (11) and accommodating the aluminum electrolytic capacitor (30), is filled and closed by an epoxy resin (60);
a rubber ring (51) is wound on side surfaces of the aluminum electrolytic capacitor's main body (32);
wherein a lead wire is drawn out from a mounting surface (33) of the aluminium electrolytic capacitor's main body (32); and
wherein the rubber ring (51) prevents the epoxy resin (60) from reaching said mounting surface (33), whereby said mounting surface (33) is exposed.

2. A joint connector (10) with internal noise filter according to claim 1, wherein the noise removal elements are capacitors (30, 40) and the respective capacitors (30, 40) are connected in parallel to the terminal fitting (21A, 21B).

3. A joint connector (10) with internal noise filter according to claim 1 or 2, wherein the noise removal elements include a ceramic capacitor (40) and the aluminum electrolytic capacitor (30) with lead wires.

4. A joint connector (10) with internal noise filter according to claim 3, wherein:
the first accommodation chamber (17A) and a second accommodation chamber (17B) having an opening (17F) for incorporation are formed side by side via a separation wall in the connector housing (11) and the aluminum electrolytic capacitor (30) and the ceramic capacitor (40) are respectively incorporated into the first and second accommodation chambers (17A, 17B) via the respective openings (17F); and
the epoxy resin (60) for closing the corresponding opening (17F) is poured into the second accommodation chamber (17B) to surround the entire ceramic capacitor (40).

## Patentansprüche

1. Ein Verbinder bzw. Kammverbinder (*joint connector*) (10) mit internem Rauschfilter, der Folgendes umfasst:
ein Verbindergehäuse (11), das mit einem Gegen-Verbinder verbindbar ist;
Anschlusspassstücke (21A, 21B), die in das Verbindergehäuse (11) eingegliedert sind und mit einer Vielzahl an nebeneinanderliegenden Anschlussabschnitten (22) gebildet sind; und
eine Vielzahl an Rauschentfernungselementen, die den Rauschfilter bilden und die unterschiedliche entfernbare Frequenzbänder aufweisen,
wobei die Rauschentfernungselemente nebeneinander in Richtung einer Aneinanderreihung der Anschlussabschnitte (22) innerhalb eines Aneinanderreihungsbereichs der Anschlussabschnitte (22) im Verbindergehäuse (11) aufgenommen werden,
wobei die Rauschentfernungselemente einen Aluminium-Elektrolytkondensator (30) beinhalten,
**dadurch gekennzeichnet, dass**
eine Öffnung (17F) einer ersten Aufnahmekammer (17A), die im Verbindergehäuse (11) bereitgestellt wird und die den Aluminium-Elektrolytkondensator (30) aufnimmt, mit einem Epoxidharz (60) gefüllt und geschlossen wird;
ein Gummiring (51) auf Seitenflächen des Hauptkörpers (32) des Aluminium-Elektrolytkondensators gewickelt wird;
wobei ein Anschlussdraht von einer Montagefläche (33) des Aluminium-Elektrolytkondensator-Hauptkörpers (32) herausgeführt wird; und
wobei der Gummiring (51) verhindert, dass das Epoxidharz (60) die genannte Montagefläche (33) erreicht, wodurch die genannte Montagefläche (33) freiliegt.

2. Ein Verbinder (10) mit internem Rauschfilter nach Anspruch 1, wobei die Rauschentfernungselemente Kondensatoren (30, 40) sind und die entsprechenden Kondensatoren (30, 40) zum Anschlusspassstück (21A, 21B) parallel geschaltet sind.

3. Ein Verbinder (10) mit internem Rauschfilter nach Anspruch 1 oder 2, wobei die Rauschentfernungselemente einen keramischen Kondensator (40) und den Aluminium-Elektrolytkondensator (30) mit Anschlussdrähten beinhalten.

4. Ein Verbinder (10) mit internem Rauschfilter nach Anspruch 3, wobei:
die erste Aufnahmekammer (17A) und eine zweite Aufnahmekammer (17B), die eine Öffnung (17F) zur Inkorporierung aufweisen, über eine Trennungswand im Verbindergehäuse (11) nebeneinander gebildet werden, und wobei der Aluminium-Elektrolytkondensator (30) und der keramische Kondensator (40) jeweils in die erste und zweite Aufnahmekammer (17A, 17B) über die entsprechenden Öffnungen (17F) inkorporiert werden; und wobei
das Epoxidharz (60) zur Schließung der entsprechenden Öffnung (17F) in die zweite Aufnahmekammer (17B) eingefüllt wird, um den gesamten keramischen Kondensator (40) zu umgeben.

## Revendications

1. Un connecteur de jonction (10) avec un filtre de bruit interne, comprenant:
un boîtier de connecteur (11) pouvant être connecté à un connecteur homologue ;
des raccords de borne (21A, 21B) incorporés dans le boîtier de connecteur (11) et formés avec une pluralité de portions de borne (22) juxtaposées ; et
une pluralité de types d'éléments de suppression de bruit constituant le filtre de bruit et présentant différentes bandes de fréquence pouvant être éliminées,
sachant que les éléments de suppression de bruit sont logés côte à côte dans une direction de juxtaposition des portions de borne (22) à l'intérieur d'une plage de juxtaposition des portions de borne (22) dans le boîtier de connecteur (11),
les éléments de suppression de bruit incluent un condensateur électrolytique à l'aluminium (30),
**caractérisé en ce que**
une ouverture (17F) d'une première chambre de logement (17A) fournie dans le boîtier de connecteur (11) et logeant le condensateur électrolytique à l'aluminium (30), est remplie de et fermée par une résine époxyde (60) ;
un anneau en caoutchouc (51) est enroulé sur des surfaces latérales du corps principal de condensateur électrolytique à l'aluminium (32) ;
sachant qu'un fil de connexion est extrait hors d'une surface de montage (33) du corps principal de condensateur électrolytique à l'aluminium (32) ; et
sachant que l'anneau en caoutchouc (51) empêche que la résine époxyde (60) atteint ladite surface de montage (33), grâce à quoi ladite surface de montage (33) est exposée.

2. Un connecteur de jonction (10) avec filtre de bruit interne d'après la revendication 1, sachant que les éléments de suppression de bruit sont des condensateurs (30, 40) et que les condensateurs (30, 40) respectifs sont connectés en parallèle au raccord de borne (21A, 21B).

3. Un connecteur de jonction (10) avec filtre de bruit interne d'après la revendication 1 ou 2, sachant que les éléments de suppression de bruit incluent un condensateur céramique (40) et le condensateur électrolytique à l'aluminium (30) avec fils de connexion.

4. Un connecteur de jonction (10) avec filtre de bruit interne d'après la revendication 3, sachant que :
la première chambre de logement (17A) et une deuxième chambre de logement (17B) présentant une ouverture (17F) pour l'incorporation sont formées côte à côte via une paroi de séparation dans le boîtier de connecteur (11) et que le condensateur électrolytique à l'aluminium (30) et le condensateur céramique (40) sont respectivement incorporés dans la première et la deuxième chambre de logement (17A , 17B) via les respectives ouvertures (17F) ; et que
la résine époxyde (60) pour la fermeture de la correspondante ouverture (17F) est versée dans la deuxième chambre de logement (17B) afin d'entourer l'intégralité du condensateur céramique (40).
